# EUROPEAN PATENT SPECIFICATION

(11) **EP 3 267 773 B1**
(45) Date of publication and mention of the grant of the patent: **18.12.2019**
(21) Application number: 17178778.1
(22) Date of filing: 29.06.2017
(51) Int. Cl.: H05K 7/20, G02F 1/1333

(54) **SYSTEM FOR THE THERMAL CONTROL OF AN ELECTRONIC PANEL FOR THE REPRODUCTION OF IMAGES**
SYSTEM ZU THERMISCHEN KONTROLLE EINES ELEKTRONISCHEN SCHIRMS ZUR WIEDERGABE VON BILDERN
SYSTÈME DE CONTROLE THERMIQUE D'UN ÉCRAN ÉLECTRONIQUE POUR LA REPRODUCTION DES IMAGES

(30) Priority: 04.07.2016 IT 201600069274
(43) Date of publication of application: 10.01.2018
(73) Proprietor: IMECON ENGINEERING S.R.L., 26010 Fiesco (CR) (IT)
(72) Inventor: VAIRANI, Fabio, I-26013 CREMA (CR) (IT); VAIRANI, Alessio, I-26012 CASTELLEONE (CR) (IT)
(74) Representative: Porta & Consulenti Associati S.p.A.

(56) References cited:
- WO-A1-2013/182733
- US-A- 5 991 153
- US-A1- 2013 170 139

## Description

The present invention relates to a system for the thermal control of an electronic panel for the reproduction of images.

Electronic panels for the reproduction of images are devices able to reproduce both static and dynamic images on the surface of a display. Such panels provide a support for a lighting system (known in technical jargon by the term of "backlight") that illuminates a screen in a controlled manner. In modern electronic panels, the backlight is a LED matrix and the screen is a liquid crystal display LCD, however, other and different light sources for the backlight and other types of technologies for the screen may be used.

This type of electronic panels for the reproduction of images is widely used both in indoor applications and in outdoor applications to convey advertising messages, information, movies and more.

In outdoor applications, a thermal control system of the electronic panel designed to ensure a correct operation of the device 24/7 plays a fundamental role, as the electronic panel must be able to operate exposed to atmospheric agents and to seasonal and daily environmental conditions of the place in which it is installed.

One of the major problems encountered in this type of applications of electronic panels is the proper cooling of the panel. Consider in fact that the backlight of a 90-inch electronic panel produces a thermal power of about 3 kilowatts, and that the solar radiation that impinges the panel can transmit thermal powers of the order of 1.5 kilowatts to the same on sunny days. The display, on the contrary, produces only a few watts of thermal power.

All thermal power needs to be dissipated, or the panel may become overheated and inevitable damaged.

In this respect, cooling systems for electronic panels for reproducing images are known that comprise a conditioning device provided with compressor and evaporator to generate a flow of cooled air that is directed inside the panel. The conditioning device is usually placed at the base of a casing that, at the top, integrates the electronic panel.

Additional solutions are known for cooling electronic panels for the reproduction of images in which a closed loop circuit is provided, in which a cooling gas circulates. Such a closed circuit develops at the front of the LCD display, continues laterally to the backlight and closes at the back behind the backlight. In the part behind the backlight, the closed loop circuit is distanced from the backlight so as to leave a space between the closed circuit and the backlight. In such a space between closed circuit and backlight flows a stream of forced air, taken from the external environment and reintroduced in the external environment, which impinges the backlight and the closed loop circuit at the back. In this way, the cooling gas removes heat from the display by convection and is cooled by the air flow taken from the external environment. This air flow also cools the rear side of the backlight by convection. Such a solution is for example described in EP2225603B1.

Further solutions for cooling electronic panels for the reproduction of images are disclosed in document US 2013/170139A1 and document WO 2013/182733A1. Document US 2013/170139A1 discloses a system for cooling an electronic image assembly having a plurality of cooling gas pathways place behind the electronic image assembly. A first fan is used to force cooling gas through a first grouping of cooling gas pathways while a second fan is used to force cooling gas through a second grouping of cooling gas pathways. Temperature sensing devices are positioned so as to measure the temperature of the first and second groupings of cooling gas pathways and for adjusting the speeds of the first and second fans. Document WO 2013/182733A1 discloses an information display comprising a housing, a display panel, a backlight unit, a first air channel between the display panel and the backlight unit. A second air channel conducts at least part of the heat generated by the backlight unit outside the information display. The first cooling air flow is separated from the second cooling air flow.

The Applicant has noticed that the cooling systems which involve the use of air conditioners, though efficient from the point of view of the cooling and maintaining maximum operating temperatures of the panel within controlled limits, involve considerable constructional complexity of the device that integrates the electronic panel (the conditioner having to be on-board), require constant maintenance, have considerable production and operating costs and result in an increase of the volume of the device that integrates the electronic panel, making these systems little usable.

The Applicant has also noticed that in the devices of the type described in EP2225603B1, if the temperature of the panel increases quickly, the thermal inertia of the device may be such as to not guarantee a lowering of the operating temperature unless the closed loop circuit and the fans are oversized to force the air of the external environment on the rear part of the backlight and on the closed loop circuit. However, such oversizing, as well as increasing the weight and the dimensions of the electronic panel, results in a further increase of the thermal inertia of the device, thus requiring a constant and careful monitoring of the temperature of the internal components, of the ambient temperature, of the thermal power transmitted by the solar radiation and a very complex management logic of the cooling system to ensure proper operation.

The Applicant has perceived that a correct thermal control of electronic panels for the reproduction of images would require avoiding the accumulation of heat inside the panel to decrease the thermal inertia thereof.

The Applicant has perceived that in order to avoid such accumulation of heat, it would be useful to remove the greatest amount of heat possible where the heat is mainly produced, namely at the backlight.

The Applicant has perceived that the mere removal of heat from the rear surface of the backlight may not avoid the accumulation of heat in the panel, since the heat produced by the backlight during the operation of the panel can easily move towards the display, thereby creating a zone between the backlight and the display which acts as a heat accumulator.

The Applicant has also noticed that such an area between the display and the backlight is further subject to heating by the effect of the solar radiation impinging the display.

The Applicant has perceived that by removing heat also in the area between the backlight and the display it is possible to decrease the thermal inertia of the panel and obtain an efficient cooling system of the panel.

The present invention therefore relates to a system for the thermal control of an electronic panel for the reproduction of images equipped with a backlight having a rear surface and a front surface opposite the rear surface and a display facing the front surface of the backlight, the system comprising:
a first heatsink thermally associated with the rear surface of the backlight;
a first closed circuit, in which a cooling fluid flows, which comprises a first fluid circulation chamber formed between the front surface of the backlight and the display, wherein said cooling fluid flows over the front surface of the backlight;
said first closed circuit comprising a heat regeneration chamber for said cooling fluid arranged in fluid communication with said first circulation chamber and thermally associated with said heatsink.

Hereinafter in the present description and in the following claims, the terms "transverse" and "transversally" are used with reference to a substantially horizontal direction perpendicular to the display (or displays) of the panel when installed. In particular, the term "transversally front" or "transversally outside" identifies a position facing more towards the outside of the panel and the term "transversally rear" or "transversally inside" identifies a position facing more towards the inside of the panel.

The term "axial" is used with reference to a direction substantially horizontal when the panel is in use, perpendicular to the transverse direction parallel to the development of the display.

The expressions "radially inner" and "radially outer" respectively indicate a more external positioning, i.e. more towards the periphery of the panel, and a more internal positioning, i.e. more towards the center of the panel.

The term "panel" refers to the entire device capable of reproducing images, including the frame housing all the components which allow a correct operation of the device.

According to the present invention, the positioning of the first closed circuit between the display and the backlight allows removing heat by convection from the front surface of the backlight while preventing such a heat from massively reaching the display and accumulating in the gap between the display and the backlight, thereby creating a considerable thermal inertia in the panel.

The cooling fluid which removes heat from the front surface of the backlight is also cooled by flowing over the first heatsink in such a way as to be reintroduced between the front surface of the backlight and the display and remove heat again from the front surface of the backlight. The heatsink which has the function of cooling the fluid of the first closed circuit also has the function of cooling by conduction the rear surface of the backlight, thereby improving the heat exchange compared to solutions in which the backlight is subsequently cooled by convection.

Preferably, the first heatsink comprises a plurality of bodies equipped with respective inner through cavities in fluid communication with an inlet and an outlet of a cooling circuit distinct from the first closed circuit; flow generating members being active between said inlet and said outlet of the cooling circuit to create a stream of fluid in said inner cavities.

The cooling circuit flow that impinges and passes through the inner cavities allows removing heat from the heatsink. Such a flow may be a flow of taken from the environment external to the panel, or a flow of conditioned air from an air conditioner, or even a flow of a closed circuit which, in turn, is cooled by heat exchange with a cold source.

Preferably, the cooling circuit is an open circuit in which air taken from and reintroduced into the external environment flows; the members generating such a flow being a plurality of fans.

Preferably, in each through cavity of the bodies of the first heatsink, a respective fan is active which takes air from the environment external to the panel and sends it inside the through cavity.

In the preferred embodiment of the invention, the first heatsink is a body made of a metal material provided with cooling fins. The cooling fins are placed inside the through cavities and protrude radially towards the center of the respective cavity, in such a way as to maximize the heat exchange with the first heatsink cooling circuit flow.

Preferably, the first heatsink is placed in contact, with possible interposition of a thermally conductive paste or other high thermal conductivity material, with the rear surface of the backlight. The surface of the first heatsink in contact with the backlight is preferably a continuous surface, in such a way as to maximize the heat exchange surface between the two components.

In the preferred embodiment of the invention, each body of the first heatsink forms a modular body capable of operating independently of the other modular bodies. In this way, depending on the axial dimensions of the backlight, which are a function of the footprint of the display on which to display images, the first heatsink can be assembled by axially placing side by side an adequate number of modular bodies, without the need for monolithic, customized heatsinks.

Preferably, fluid circulation members are active in said first closed circuit for circulating said cooling fluid between the first circulation chamber and the regeneration chamber.

In the preferred embodiment of the invention, the fluid circulation members are a plurality of fans active between the first circulation chamber and the regeneration chamber, to send heated cooling fluid from the first circulation chamber to the regeneration chamber, and between the regeneration chamber and the first circulation chamber, to send cooled cooling fluid from the regeneration chamber to the first circulation chamber.

In a first embodiment of the invention, said first closed circuit comprises a second fluid circulation chamber formed between the display and a protective screen arranged transversally outside of the display; said first and second circulation chamber being in fluid communication. The protective screen is preferably an outermost screen of the panel and is constrained to a frame of the panel in a manner such that no fluid (gas or water) or dust can filter between the protective screen and the frame.

The second circulation chamber removes heat from the display surface opposite that facing the backlight, and also creates a steady stream that flows over the protective screen, preventing the latter from transmitting significant thermal powers, for example generated by solar irradiation, towards the display.

In this first embodiment of the invention, said heat regeneration chamber comprises a vertical duct arranged transversally outside of said first heatsink and axially outside of said backlight; the flow of cooling fluid in said first circulation chamber having a vertical direction and being in counter-current with respect to the flow of cooling fluid in said vertical duct.

In this way, a cooling flow is established that vertically sweeps the front wall of the backlight, the display and the protective screen, and which is then conveyed into the regeneration chamber to return again to vertically sweep the front wall of the backlight, the display and the protective screen.

Preferably, the regeneration chamber comprises two axially opposed vertical ducts, each of which is arranged transversally outside of said first heatsink and axially outside of said backlight. In this way, the heated cooling fluid is divided into two streams, each of which crosses the respective vertical duct and then combines again in a single cooled fluid stream.

In a second embodiment of the invention, a second closed circuit is preferably provided in which a further cooling fluid flows, said second closed circuit comprising a fluid circulation chamber arranged between the display and a protective screen transversally outside of the display and a heat regeneration chamber arranged in fluid communication with said circulation chamber and thermally associated with a second heatsink.

The second closed circuit functionally replaces the second circulation chamber of the first embodiment.

Preferably, the second heatsink is structurally identical to one or more of the modular bodies that form the first heatsink and is traversed by air taken from the external environment. Preferably, a respective fan is active also in the second heatsink to force the circulation of air taken from the external environment.

Preferably, the heat regeneration chamber of the second closed circuit is axially arranged between the circulation chamber of the second closed circuit and the second heatsink.

In this embodiment of the invention, the heat regeneration chamber of the second closed circuit comprises a vertical duct; the flow of cooling fluid in said circulation chamber of the second closed circuit having a vertical direction and being in counter-current with respect to the flow of cooling fluid in said vertical duct.

In this way, a cooling flow is established that vertically sweeps the display and the protective screen, and which is then conveyed into the regeneration chamber to return again to vertically sweep the display and the protective screen.

Preferably, the regeneration chamber of the second closed circuit comprises two axially opposed vertical ducts, each of which is arranged axially outside of the circulation chamber of the second closed circuit. A respective second heatsink is arranged axially outside of each vertical duct. In this way, the heated cooling fluid is divided into two streams, each of which crosses the respective vertical duct and then combines again in a single cooled fluid stream.

Preferably, fluid circulation members are active in the second closed circuit for circulating the cooling fluid between the circulation chamber and the regeneration chamber.

Similar to the first embodiment of the invention, the fluid circulation members preferably are a plurality of fans active between the circulation chamber and the regeneration chamber, to send heated cooling fluid from the circulation chamber to the regeneration chamber, and between the regeneration chamber and the circulation chamber, to send cooled cooling fluid from the regeneration chamber to the circulation chamber.

Preferably, an opaque screen is arranged transversally inside and in contact with said display; said opaque screen physically separating said first from said second closed circuit.

Preferably, the opaque screen is made of a material having a low thermal conductivity, such as glass. Thin layers of polymeric material are preferably applied on one or both surfaces of the opaque screen wherein the layers of polymeric material are able to orient the light beams coming from the backlight directed towards the display in perpendicular direction.

In the second embodiment of the invention, the regeneration chamber of the first closed circuit is preferably arranged transversally inside of said first heatsink on the opposite side with respect to the first chamber; said first closed circuit surrounding and licking an assembly made from said backlight and said first heatsink. The first circulation chamber, as in the first embodiment, develops between the backlight and the display.

In this way, the flow of cooling fluid in said first circulation chamber has an axial direction and is in counter-current with respect to the flow of cooling fluid in said regeneration chamber.

The heated cooling fluid coming from the first circulation chamber of the first closed circuit is cooled in the regeneration chamber by the effect of the heat exchange with outer walls of the first heatsink.

In a third embodiment of the invention, the panel is of two-side type, i.e. has two independent displays, each facing a respective backlight.

This third embodiment of the invention has all the features of the second embodiment and, in addition, provides an additional backlight arranged transversally outside and facing the backlight of the second embodiment and a further display arranged transversally outside on the opposite side with respect to the first chamber and facing the further backlight.

Preferably, the first circulation chamber of the first closed circuit also extends between the further backlight and the further display.

In the third embodiment of the invention, the heat regeneration chamber of the first closed circuit is preferably formed between the backlight and the further backlight and is in fluid communication with the first and second circulation chamber.

Preferably, a third closed circuit is provided in which a further cooling fluid flows, said third closed circuit comprising a fluid circulation chamber arranged between the further display and a further protective screen transversally outside of the further display and a heat regeneration chamber arranged in fluid communication with said circulation chamber and thermally associated with a third heatsink.

The third heatsink is structurally identical to the second heatsink. Preferably, a respective fan is active in the third heatsink to force the circulation of air taken from the external environment.

Preferably, the heat regeneration chamber of the third closed circuit is axially arranged between the circulation chamber of the third closed circuit and the third heatsink.

In this embodiment of the invention, the heat regeneration chamber of the third closed circuit comprises a vertical duct; the flow of cooling fluid in said circulation chamber of the third closed circuit having a vertical direction and being in counter-current with respect to the flow of cooling fluid in said vertical duct.

In this way, a cooling flow is established that vertically sweeps the front wall, the further display and the further protective screen, and which is then conveyed into the regeneration chamber to return again to vertically sweep the further display and the further protective screen.

Preferably, the regeneration chamber of the third closed circuit comprises two axially opposed vertical ducts, each of which is arranged axially outside of the circulation chamber of the third closed circuit. A respective third heatsink is arranged axially outside of each vertical duct. In this way, the heated cooling fluid is divided into two streams, each of which crosses the respective vertical duct and then combines again in a single cooled fluid stream.

Preferably, fluid circulation members are active in the third closed circuit for circulating the cooling fluid between the circulation chamber and the regeneration chamber.

Such fluid circulation members preferably are a plurality of fans active between the circulation chamber and the regeneration chamber, to send heated cooling fluid from the circulation chamber to the regeneration chamber, and between the regeneration chamber and the circulation chamber, to send cooled cooling fluid from the regeneration chamber to the circulation chamber.

Preferably, a further opaque screen is arranged transversally inside and in contact with said further display; said opaque screen physically separating said first from said third closed circuit.

Further features and advantages of the present invention will appear more clearly from the following detailed description of some preferred embodiments thereof, made with reference to the accompanying drawings, given by way of non-limiting example. In such drawings:
- figure 1 is a schematic, transverse section top view of a system for the thermal control of an electronic panel for the reproduction of images according to a first embodiment of the present invention;
- figure 2 is a view according to section II-II of the system in figure 1;
- figure 3 is a view according to section III-III of the system in figure 2;
- figure 4 is a transverse section top view of a system for the thermal control of an electronic panel for the reproduction of images according to a second embodiment of the present invention;
- figure 5 is a view according to section V-V of the system in figure 4;
- figure 6 is a view according to section VI-VI of the system in figure 4;
- figure 7 is a transverse section top view of a system for the thermal control of an electronic panel for the reproduction of images according to a third embodiment of the present invention;
- figure 8 is a view according to section VIII-VIII of the system in figure 4; and
- figure 9 is a view according to section IX-IX of the system in figure 8.

In the accompanying figures, reference numeral 10 indicates a system for the thermal control of an electronic panel for the reproduction of images according to a first embodiment of the present invention.

Unless otherwise expressly noted, the features of the systems for the thermal control of an electronic panel for the reproduction of images referred to in the various embodiments must be understood as common to all systems.

System 10 is configured for being used in panels in which a backlight 100 is provided, for example but not exclusively a plurality of supports for LED arrays, having a front surface 101 facing to a screen 200, for example but not exclusively an LCD screen.

System 10 comprises a first closed circuit 11 in which a cooling fluid circulates. The first closed circuit 11 is fluidly isolated from the outside, namely the cooling fluid is not in fluid communication with the environment external to the first closed circuit 11. The cooling fluid is in a gaseous state and can be air, nitrogen or an inert gas.

The first closed circuit 11 comprises a first circulation chamber 12 which is formed between the front surface 101 of backlight 100 and display 200.

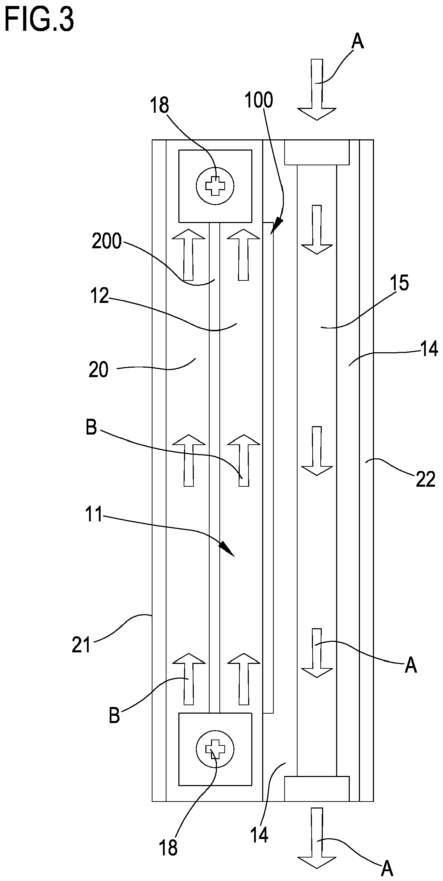

A first heatsink 13 is thermally active on the rear surface 102 of backlight 100. This first heatsink 13 is placed directly in contact, with possible interposition of a thermally conductive paste or other high thermal conductivity material, with the rear surface 102 of backlight 100. The first heatsink 13 comprises a plurality of modular bodies 14 identical to each other and placed axially side by side. Each modular body 14 is substantially a right prism having a quadrangular base. The number of modular bodies 14 is selected in such a way as to extend the first heatsink 13 by at least the entire axial extension of backlight 100. Likewise, the height, i.e. the vertical extension of the modular bodies 14 is selected so as to extend at least throughout the height of backlight 100, as illustrated in the accompanying figures. Each modular body 14 comprises a respective inner through cavity 15 in fluid communication with an inlet and an outlet of an open cooling circuit, namely a cooling circuit that takes air from the environment external to the panel the panel and releases air to the environment external to the panel. The air from the external environment is taken and expelled by flow generating members 16, such as fans, active on each inner cavity 15 in such a way as to establish a stream directed vertically within each modular body 14. Figures 3, 8 and 9 show the vertical stream generated within each modular body 14 with arrows A. The direction of this stream may be from the bottom upwards or from the top downwards (the latter direction is that schematized in the above figures).

Each modular body 14 is made of a metal material and is equipped with cooling fins (not shown) which extend into the inner cavity 15 radially projecting towards the center thereof, in such a way as to be impinged by the air flow passing through the inner cavity 15.

The aforementioned first closed circuit 11 comprises a regeneration chamber arranged in fluid communication with the first circulation chamber 12. The regeneration chamber 17 is thermally associated with the first heatsink 13, i.e. it exchanges thermal energy with the first heatsink 13.

Fluid circulation members 8, such as fans, are active in the first closed circuit 11 for circulating the cooling fluid between the first circulation chamber 12 and the regeneration chamber 17.

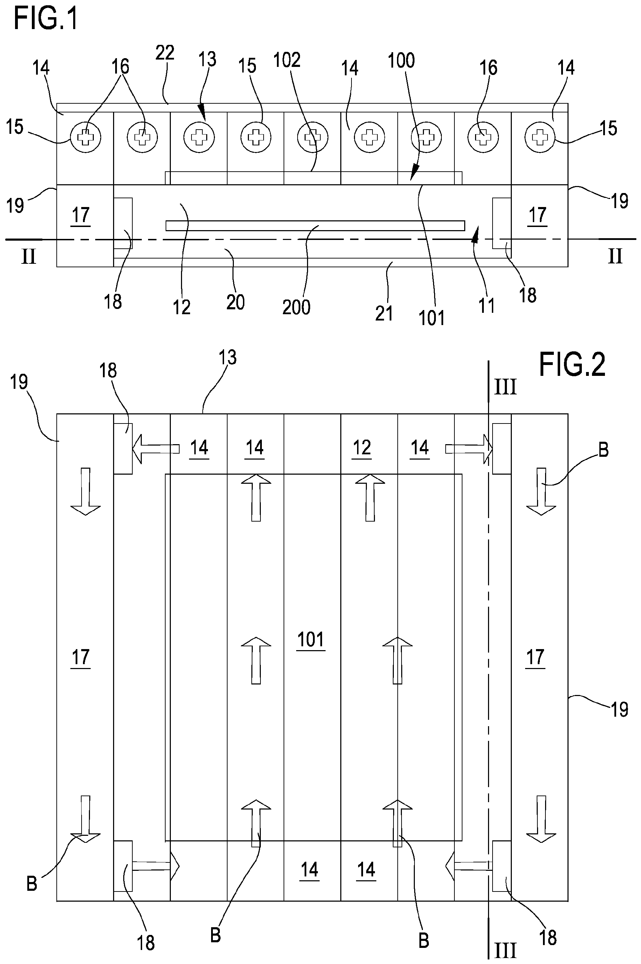

In the first embodiment of the invention, the regeneration chamber 17 comprises two vertical ducts 19, each of which is arranged transversally outside of, i.e. in front of, the first heatsink 13, as shown in figure 1. Each of the two vertical ducts 19 is arranged axially outside of the first circulation chamber 12, outside of the footprint of backlight 100 and display 200. The two vertical ducts 19 are in direct contact with one or more modular bodies 14 of the first heatsink 13 in such a way that the latter can cool the walls of the vertical ducts 19 and thus the cooling flow that circulates therein.

The flow of the cooling fluid in the first circulation chamber 12 and in the lateral ducts 19 is directed vertically, as indicated by arrows B in figures 2 and 3. In particular, the flow of the cooling fluid in the first circulation chamber 12 is in counter-current with respect to the flow of cooling fluid in the two vertical ducts 19. Fans 18 to circulate the cooling fluid in the first closed circuit 11 are arranged adjacent to the vertical ducts 19 and send cooling fluid from the first circulation chamber 12 to the vertical ducts 19 and from the vertical ducts 19 to the first circulation chamber 12.

In the first embodiment of the invention, the first closed circuit 11 comprises a second circulation chamber 20 formed between display 200 and a protective screen 21 arranged to protect the front part of the panel. The protective screen 21 is closed in a fluidtight manner on the panel. The second circulation chamber 20 is arranged in fluid communication with the first circulation chamber 12 and with the regeneration chamber 17. In particular, the first 12 and the second circulation chamber 20 join in axially opposed areas arranged axially outside of display 200 and axially inside of the vertical ducts 19, as shown in figure 1. The flow of the cooling fluid within the second circulation chamber 20 is directed according to the flow within the first circulation chamber 12, as shown schematically in figure 3. The vertical ducts 19 also provide to the cooling of the cooling fluid flowing in the second circulation chamber 20.

In the first embodiment of the invention, in a direction transversally outside of the first heatsink 13 on the opposite side with respect to backlight 100, i.e. behind the first heatsink 13, there is a rear screen 22 made of a thermally insulating material to prevent thermal waves from reaching heatsink 13 from the rear wall of the panel.

The second embodiment of the invention differs from the first embodiment in the positioning of the regeneration chamber 17 and in the absence of the second circulation chamber 20 within the first closed circuit 11.

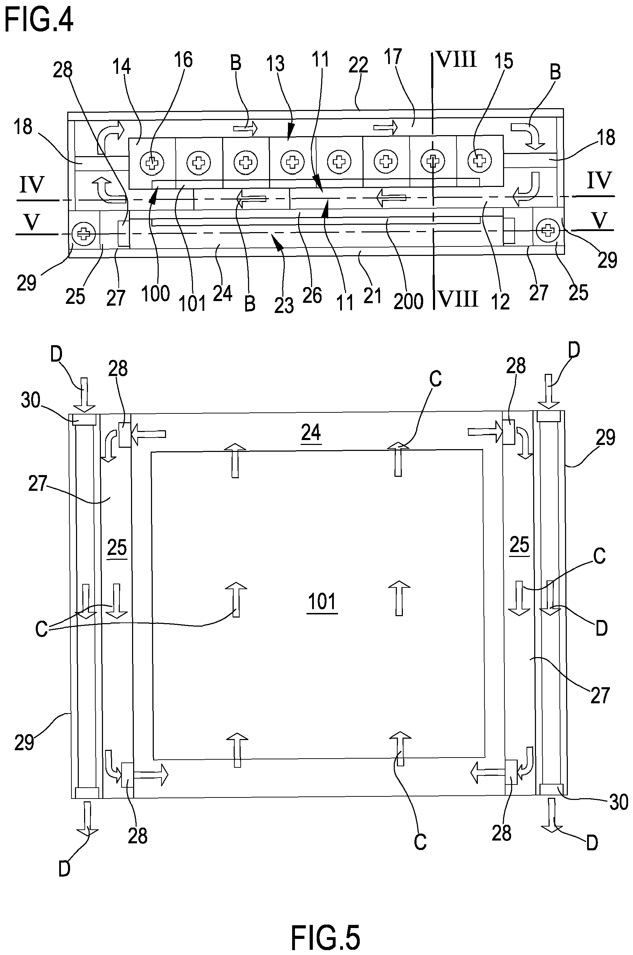

In the second embodiment of the invention, the regeneration chamber 17 is positioned transversally outside of the first heatsink 13, i.e. behind the same on the opposite side with respect to backlight 100, as indicated schematically in figure 4. The regeneration chamber 17 is confined between the first heatsink 13 and the rear screen 22 which, in this embodiment, is transversally spaced from the first heatsink 13. The flow of cooling fluid circulating in the regeneration chamber flows to the first heatsink 13 to be cooled.

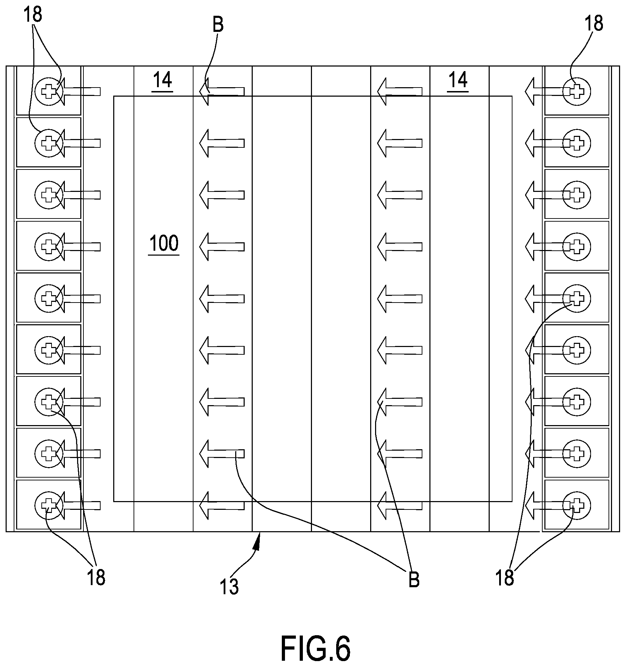

The first closed circuit 11 therefore produces an annular path that internally encloses the first heatsink 13 and backlight 100. The direction of the cooling fluid flow in the first closed circuit 11, indicated by arrows B in figure 4 and 6, is axial and in counter-current in the circulation chamber 12 and in the regeneration chamber 17.

In the second embodiment of the invention, a second closed circuit 23 is provided in which a further cooling fluid circulates. The second closed circuit 23 comprises a circulation chamber 24 and a regeneration chamber 25 arranged in fluid communication with the circulation chamber 24.

The circulation chamber 24 is formed between display 200 and the protective screen 21 and is separated from the first circulation chamber 12 of the first closed circuit 11 by an opaque screen 26 arranged transversally inside of display 200, i.e. facing backlight 100. The opaque screen 26 physically divides the first 11 from the second closed circuit 23, thus preventing the cooling fluids of the two circuits from coming into contact. Since the opaque screen 26 is interposed between backlight 100 and display 200, it is made of a material suitable for allowing backlight 100 to properly illuminate display 200. In this regard, layers of polymeric material are applied on the opaque screen 26 capable of orienting the light beams coming from backlight 100 and directed towards display 100 in a direction perpendicular to display 200.

The opaque screen 26 is also made of high heat-resistant material, such as glass. The opaque screen 26 therefore thermally isolates display 100 from backlight 200.

The regeneration chamber 25 comprises two vertical ducts 27, each of which is arranged transversally outside of, i.e. in front of, the first circulation chamber 12 of the first closed circuit 11, as shown in figure 4. Each of the two vertical ducts 27 is arranged axially outside of the circulation chamber 24 of the second closed circuit 23, out of the footprint of backlight 100 and of display 200. The flow of the cooling fluid in the second circulation chamber 23 and in the lateral ducts 27 is directed vertically, as indicated by arrows C in figure 5. In particular, the flow of the cooling fluid in the circulation chamber 25 is in counter-current with respect to the flow of cooling fluid in the two vertical ducts 27. Flow generating members 28, in particular fans, circulate the cooling fluid in the second closed circuit 23 and are arranged in the vicinity of the vertical ducts 27, sending cooling fluid from the circulation chamber 25 to the vertical ducts 27 and from the vertical ducts 27 to the circulation chamber 25.

The regeneration chamber 25 is thermally coupled to a second heatsink 29, in particular to a pair of second heatsinks 29 arranged axially outside of the regeneration chamber 25.

Each second heatsink 29 is structurally identical to one or more of the modular bodies 14 that form the first heatsink 13 and is traversed by air taken from the external environment, as indicated by arrows D in figure 5. Preferably, at least one respective fan 30 is active in each second heatsink 29 to force the circulation of air taken from the external environment. The two vertical ducts 27 are in direct contact with a respective modular body of the second heatsink 29 in such a way that the latter can cool the walls of the vertical ducts 27 and thus the cooling flow that circulates therein. The vertical ducts 27 are axially interposed between the modular bodies of the second heatsink 29 and the circulation chamber 25.

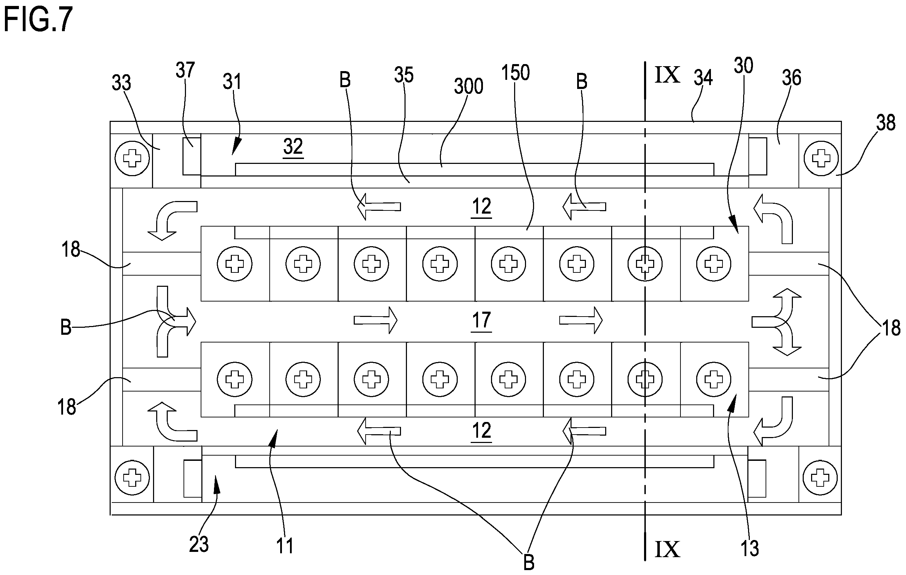

The third embodiment relates to a two-side panel, i.e. in which the images are displayed on two transversally opposite displays. The third embodiment is structurally given by the combination of the two systems referred to in the second embodiment, in which one of such systems is mirrored with respect to a plane transversally arranged in the regeneration chamber 17 of the first closed circuit 11 (and in which the rear screen 22 has been removed). In this embodiment, a further display backlight 150 and a further display 300 facing backlight 150 are provided (figure 7). The first circulation chamber 12 of the first closed circuit 11 also develops between the further backlight 150 and the further display 300 exactly as described in relation to backlight 100 and display 200 of the second embodiment. Transversally inside of the further backlight 150 and in thermal contact with the latter there is a third heatsink 30 identical and transversally specular to the first heatsink 13. The third heatsink 30 is transversally spaced from the first one 13 and the space between them is occupied by the regeneration chamber 17 of the first closed circuit 11. The regeneration chamber 17 is common to both portions of the first circulation chamber 12. Further fans 18 circulate cooling fluid also in the portion of first circulation chamber arranged between the further backlight 150 and the further display 300.

Transversally outside of the portion of first circulation chamber 12 arranged between the further backlight 150 and the further display 300 there is provided a third closed circuit 31 identical and transversally specular with respect to the second closed circuit 23.

The third closed circuit 31 comprises a circulation chamber 32 and a regeneration chamber 33 arranged in fluid communication with the circulation chamber 32.

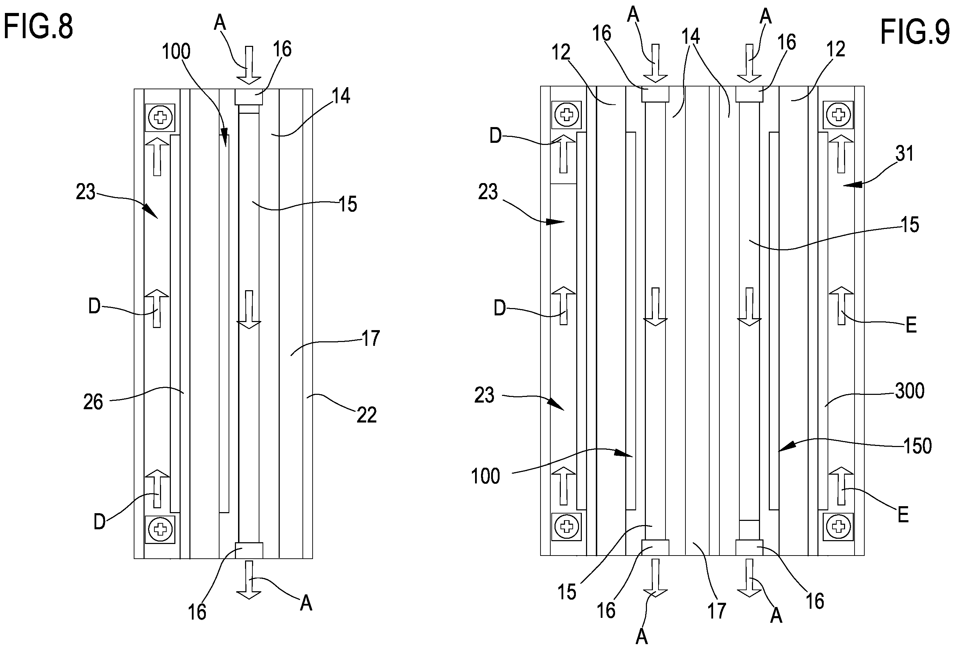

The circulation chamber 32 is formed between the further display 300 and a transversally outside further protective screen 34 and is separated from the first circulation chamber 12 of the first closed circuit 11 by an opaque screen 35 arranged transversally inside of the further display 300, i.e. facing the further backlight 150. The opaque screen 35 physically divides the first 11 from the third closed circuit 31, thus preventing the cooling fluids of the two circuits from coming into contact. The regeneration chamber 33 comprises two vertical ducts 36, each of which is arranged transversally outside of, i.e. in front of, the first circulation chamber 12 of the first closed circuit 11, as shown in figure 7. Each of the two vertical ducts 36 is arranged axially outside of the circulation chamber 32 of the third closed circuit 31, out of the footprint of the further backlight 150 and of the further display 300. The flow of the cooling fluid in the third circulation chamber 31 and in the lateral ducts 36 is directed vertically, as indicated by arrows E in figure 9. In particular, the flow of the cooling fluid in the circulation chamber 32 is in counter-current with respect to the flow of cooling fluid in the two vertical ducts 36. Flow generating members 37, in particular fans, circulate the cooling fluid in the third closed circuit 31 and are arranged in the vicinity of the vertical ducts 36, sending cooling fluid from the circulation chamber 32 to the vertical ducts 36 and from the vertical ducts 36 to the circulation chamber 32.

The regeneration chamber 33 is thermally coupled to a fourth heatsink 38, in particular to a pair of second heatsinks 38 arranged axially outside of the regeneration chamber 33.

Each fourth heatsink 33 is structurally identical to one or more of the modular bodies 14 that form the first heatsink 13 and is traversed by air taken from the external environment. Preferably, at least one respective fan is active in each fourth heatsink 38 to force the circulation of air taken from the external environment. The two vertical ducts 36 are in direct contact with a respective modular body of the fourth heatsink 38 in such a way that the latter can cool the walls of the vertical ducts 36 and thus the cooling flow that circulates therein. The vertical ducts 36 are axially interposed between the modular bodies of the fourth heatsink 38 and the circulation chamber 32.

Of course, a man skilled in the art may make several changes and adjustments to the invention described above in order to meet specific and incidental needs, all falling within the scope of protection of the present invention as defined in the following claims.

## Claims

1. System (10) for the thermal control of an electronic panel for the reproduction of images equipped with a backlight (100) having a rear surface (102) and a front surface (101) opposite the rear surface (102) and a display (200) facing the front surface (101) of the backlight (100), the system comprising:
a first heatsink (13) thermally associated with the rear surface (102) of the backlight (100);
a first closed circuit (11), in which a cooling fluid flows, which comprises a first fluid circulation chamber (12) formed between the front surface (101) of the backlight (100) and the display (200), wherein said cooling fluid flows over the front surface (101) of the backlight (100);
said first closed circuit (11) comprising a heat regeneration chamber (17) for said cooling fluid arranged in fluid communication with said first circulation chamber (12);
**characterized in that** said heat regeneration chamber (17) is thermally associated with said first
heatsink (13) so that the heated cooling fluid (11) is cooled in said first heat regeneration chamber (17).

2. System (10) according to claim 1, wherein said first heatsink (13) comprises a plurality of bodies (14) equipped with respective inner through cavities (15) in fluid communication with an inlet and an outlet of a cooling circuit distinct from the first closed circuit (11); flow generating members (16) being active between said inlet and said outlet of the cooling circuit to create a stream of fluid in said inner cavities (15).

3. System (10) according to claim 2, wherein said cooling circuit of the first heatsink (13) is an open circuit in which air taken from and reintroduced into the external environment flows; said flow generating members (16) being a plurality of fans.

4. System (10) according to any one of the previous claims comprising fluid circulation members (18) active in said first closed circuit (11) for circulating said cooling fluid between the first circulation chamber (12) and the regeneration chamber (17).

5. System (10) according to any one of the previous claims, wherein said first closed circuit (11) comprises a second fluid circulation chamber (20) formed between the display (200) and a protective screen (21) arranged transversally outside of the display (200); said first (12) and second circulation chamber (17) being in fluid communication.

6. System (10) according to any one of the previous claims, wherein said heat regeneration chamber (17) comprises a vertical duct (19) arranged transversally outside of said first heatsink (13) and axially outside of said backlight (100); the flow of cooling fluid in said first circulation chamber (12) having a vertical direction and being in counter-current with respect to the flow of cooling fluid in said vertical duct (19).

7. System (10) according to any one of claims 1 to 4 comprising a second closed circuit (23) in which a further cooling fluid flows, said second closed circuit (23) comprising a fluid circulation chamber (24) arranged between the display (200) and a protective screen (21) transversally outside of the display (200) and a heat regeneration chamber (25) arranged in fluid communication with said circulation chamber (24) and thermally associated with a second heatsink (29).

8. System (10) according to claim 7, wherein said heat regeneration chamber (25) of the second closed circuit (23) is axially arranged between the circulation chamber (24) of the second closed circuit (23) and said second heatsink (29).

9. System (10) according to claim 8, wherein said heat regeneration chamber (25) of the second closed circuit (23) comprises a vertical duct (27); the flow of cooling fluid in said circulation chamber (24) of the second closed circuit (23) having a vertical direction and being in counter-current with respect to the flow of cooling fluid in said vertical duct (27).

10. System (10) according to any one of claims 7 to 9, comprising an opaque screen (26) arranged transversally inside and in contact with said display (200); said opaque screen (26) physically separating said first (11) from said second closed circuit (23).

11. System (10) according to any one of claims 7 to 10, wherein said regeneration chamber (17) of the first closed circuit (11) is arranged transversally outside of said first heatsink (13) on the opposite side with respect to the first circulation chamber (12); said first closed circuit (11) surrounding and licking an assembly made from said backlight (100) and said first heatsink (13).

12. System (10) according to claim 11, wherein the flow of cooling fluid in said first circulation chamber (12) of the first closed circuit (11) has an axial direction and is in counter-current with respect to the flow of cooling fluid in said regeneration chamber (17).

13. System (10) according to any one of claims 7 to 12 equipped with a further backlight (150) transversally outside of and facing the backlight (100) and a further display (300) transversally outside of the further backlight (150), on the opposite side with respect to the first circulation chamber (12), and facing the further backlight (150), said first closed circuit (11) also extending between the further backlight (150) and the further display (300), wherein said cooling fluid flows over said further backlight (150).

14. System (10) according to claim 13, wherein said heat regeneration chamber (17) of the first closed circuit (11) is formed between the backlight (100) and the further backlight (150) and is in fluid communication with the first circulation chamber (12).

15. System (10) according to claim 13 or 14, comprising a third closed circuit (31) in which a further cooling fluid flows, said third closed circuit (31) comprising a fluid circulation chamber (32) arranged between the further display (300) and a further protective screen (34) transversally outside of the further display (300) and a heat regeneration chamber (33) arranged in fluid communication with said circulation chamber (32) and thermally associated with a third heatsink (38).

16. System (10) according to any one of claims 13 to 15, comprising a further opaque screen (35) arranged transversally inside and in contact with said further display (300); said further opaque screen (35) physically separating said first (11) from said third closed circuit (31).

## Patentansprüche

1. System (10) zur thermischen Kontrolle eines elektronischen Schirms zur Wiedergabe von Bildern, ausgestattet mit einer Hintergrundbeleuchtung (100) mit einer Rückseite (102) und einer Vorderseite (101), die der der Rückseite (102) gegenüberliegt, und mit einer Anzeige (200), die der Vorderseite (101) der Hintergrundbeleuchtung (100) zugewandt ist, wobei das System umfasst:
einen ersten mit der Rückseite (102) der Hintergrundbeleuchtung (100) thermisch verbundenen Kühlkörper (13);
einen ersten geschlossenen Kreislauf (11), in dem ein Kühlfluid strömt, das eine erste Fluidzirkulationskammer (12) umfasst, die zwischen der Vorderseite (101) der Hintergrundbeleuchtung (100) und der Anzeige (200) gebildet ist, wobei das Kühlfluid über die Vorderseite (101) der Hintergrundbeleuchtung (100) strömt;
wobei der erste geschlossene Kreislauf (11) eine Hitzeregenerierungskammer (17) für das Kühlfluid umfasst, die mit der ersten Zirkulationskammer (12) in fluidischer Verbindung steht;
**dadurch gekennzeichnet, dass** die Hitzeregenerierungskammer (17) mit dem ersten Kühlkörper (13) thermisch verbunden ist, so dass das erhitzte Kühlfluid (11) in der ersten Hitzeregenerierungskammer (17) gekühlt wird.

2. System (10) nach Anspruch 1, wobei der erste Kühlkörper (13) eine Mehrzahl von Körpern (14) umfasst, die mit jeweiligen durchgehenden, inneren Hohlräumen (15) ausgestattet ist, die mit einem Einlass und einem Auslass eines von dem ersten geschlossenen Kreislauf (11) getrennten Kühlkreislaufs in fluidischer Verbindung stehen; wobei Strömung erzeugende Elemente (16) zwischen dem Einlass und dem Auslass des Kühlkreislaufs wirksam sind, um einen Fluidstrom in den inneren Hohlräumen (15) zu erzeugen.

3. System (10) nach Anspruch 2, wobei der Kühlkreislauf des ersten Kühlkörpers (13) ein offener Kreislauf ist, in dem von der äußeren Umgebung entnommene und in diese zurückgeführte Luft strömt; wobei die Strömung erzeugenden Elemente (16) eine Mehrzahl von Gebläsen sind.

4. System (10) nach einem der vorstehenden Ansprüche, umfassend Strömung erzeugende Elemente (18), die in dem ersten geschlossenen Kreislauf (11) wirksam sind zum Umwälzen des Kühlfluids zwischen der ersten Zirkulationskammer (12) und der Regenerierungskammer (17).

5. System (10) nach einem der vorstehenden Ansprüche, wobei der erste geschlossene Kreislauf (11) eine zweite Fluidzirkuationskammer (20) umfasst, die zwischen der Anzeige (200) und einem Schutzschirm (21) gebildet ist, der quer außerhalb der Anzeige (200) angeordnet ist; wobei die erste (12) und die zweite Zirkulationskammer (17) in fluidischer Verbindung stehen.

6. System (10) nach einem der vorstehenden Ansprüche, wobei die Hitzeregenerierungskammer (17) einen vertikalen Kanal (19) umfasst, der quer außerhalb des ersten Kühlkörpers (13) und axial außerhalb der Hintergrundbeleuchtung (100) angeordnet ist; wobei die Strömung des Kühlfluids in der ersten Zirkulationskammer (12) eine vertikale Richtung aufweist und in Gegenströmung in Bezug auf die Strömung des Kühlfluids in dem vertikalen Kanal (19) steht.

7. System (10) nach einem der Ansprüche 1 bis 4, umfassend einen zweiten geschlossenen Kreislauf (23), in dem ein weiteres Kühlfluid strömt, wobei der zweite geschlossene Kreislauf (23) eine Fluidzirkulationskammer (24) umfasst, die zwischen der Anzeige (200) und einem Schutzschirm (21) quer außerhalb der Anzeige (200) und einer Hitzeregenerierungskammer (25) in fluidischer Verbindung mit der Zirkulationskammer (24) angeordnet und mit einem zweiten Kühlkörper (29) thermisch verbunden ist.

8. System (10) nach Anspruch 7, wobei die Hitzeregenerierungskammer (25) des zweiten geschlossenen Kreislaufs (23) axial zwischen der Zirkulationskammer (24) des zweiten geschlossenen Kreislaufs (23) und dem zweiten Kühlkörper (29) angeordnet ist.

9. System (10) nach Anspruch 8, wobei die Hitzeregenerierungskammer (25) des zweiten geschlossenen Kreislaufs (23) einen vertikalen Kanal (27) umfasst, wobei der Kühlfluidstrom in der Zirkulationskammer (24) des zweiten geschlossenen Kreislaufs (23) eine vertikale Richtung aufweist und in Gegenströmung in Bezug auf die Strömung des Kühlfluids in dem vertikalen Kanal (27) steht.

10. System (10) nach einem der Ansprüche 7 bis 9, umfassend einen lichtundurchlässigen Schirm (26), der quer innerhalb und im Kontakt mit der Anzeige (200) angeordnet ist; wobei der lichtundurchlässige Schirm (26) den ersten (11) vom zweiten geschlossenen Kreislauf (23) physisch trennt.

11. System (10) nach einem der Ansprüche 7 bis 10, wobei die Regenerierungskammer (17) des ersten geschlossenen Kreislaufs (11) quer außerhalb des ersten Kühlkörpers (13) auf der gegenüberliegenden Seite in Bezug auf die erste Zirkulationskammer (12) angeordnet ist; wobei der erste geschlossene Kreislauf (11) eine aus der Hintergrundbeleuchtung (100) und dem ersten Kühlkörper (13) bestehende Gruppe umschließt und anliegt.

12. System (10) nach Anspruch 11, wobei die Kühlfluidströmung in der ersten Zirkulationskammer (12) des ersten geschlossenen Kreislaufs (11) eine axiale Richtung aufweist und in Gegenströmung
in Bezug auf die Kühlfluidströmung in der Regenerierungskammer (17) steht.

13. System (10) nach einem der Ansprüche 7 bis 12, ausgestattet mit einer weiteren Hintergrundbeleuchtung (150), die quer außerhalb der Hintergrundbeleuchtung (100) und ihr zugewandt ist, sowie mit einer weiteren Anzeige, die (300) quer außerhalb der weiteren Hintergrundbeleuchtung (150) auf der gegenüberliegenden Seite in Bezug auf die erste Zirkulationskammer (12) und der weiteren Hintergrundbeleuchtung (150) zugewandt ist, wobei der erste geschlossene Kreislauf (11) sich auch zwischen der weiteren Hintergrundbeleuchtung (150) und der weiteren Anzeige (300) erstreckt, wobei das Kühlfluid über die weitere Hintergrundbeleuchtung (150) strömt.

14. System (10) nach Anspruch 13, wobei die Hitzeregenerierungskammer (17) des ersten geschlossenen Kreislaufs (11) zwischen der Hintergrundbeleuchtung (100) und der weiteren Hintergrundbeleuchtung (150) gebildet ist und mit der ersten Zirkulationskammer (12) in fluidischer Verbindung steht.

15. System (10) nach einem der Ansprüche 13 oder 14, umfassend einen dritten geschlossenen Kreislauf (31), in dem ein weiteres Kühlfluid strömt, wobei der dritte geschlossene Kreislauf (31) eine Fluidzirkulationskammer (32) umfasst, die zwischen der weiteren Anzeige (300) und einem weiteren Schutzschirm (34) quer außerhalb der weiteren Anzeige (300) und einer Hitzeregenerierungskammer (33) in fluidischer Verbindung mit der Zirkulationskammer (32) angeordnet und mit einem dritten Kühlkörper (38) thermisch verbunden ist.

16. System (10) nach einem der Ansprüche 13 bis 15, umfassend einen weiteren lichtundurchlässigen Schirm (35), der quer innerhalb und im Kontakt mit der weiteren Anzeige (300) angeordnet ist; wobei der weitere lichtundurchlässige Schirm (35) den ersten (11) vom dritten geschlossenen Kreislauf (31) physisch trennt.

## Revendications

1. Système (10) pour la régulation thermique d'un panneau électronique pour la reproduction d'images équipé d'un dispositif de rétroéclairage (100) ayant une surface arrière (102) et une surface avant (101) opposée à la surface arrière (102) et un dispositif d'affichage (200) faisant face à la surface avant (101) du dispositif de rétroéclairage (100), le système comprenant :
un premier dissipateur thermique (13) associé thermiquement à la surface arrière (102) du dispositif de rétroéclairage (100) ;
un premier circuit fermé (11), dans lequel un fluide de refroidissement circule, qui comprend une première chambre de circulation de fluide (12) formée entre la surface avant (101) du dispositif de rétroéclairage (100) et le dispositif d'affichage (200), dans lequel ledit fluide de refroidissement s'écoule sur la surface avant (101) du dispositif de rétroéclairage (100) ;
ledit premier circuit fermé (11) comprenant une chambre de régénération de chaleur (17) pour ledit fluide de refroidissement agencée en communication fluidique avec ladite première chambre de circulation (12) ;
**caractérisé en ce que** ladite chambre de régénération de chaleur (17) est associée thermiquement audit premier dissipateur thermique (13) de manière que le fluide de refroidissement réchauffé (11) soit refroidi dans ladite première chambre de régénération de chaleur (17).

2. Système (10) selon la revendication 1, dans lequel ledit premier dissipateur thermique (13) comprend une pluralité de corps (14) équipés de cavités passantes intérieures respectives (15) en communication fluidique avec une entrée et une sortie d'un circuit de refroidissement distinct du premier circuit fermé (11) ; des éléments de génération de flux (16) étant actifs entre ladite entrée et ladite sortie du circuit de refroidissement pour créer un courant de fluide dans lesdites cavités intérieures (15).

3. Système (10) selon la revendication 2, dans lequel ledit circuit de refroidissement du premier dissipateur thermique (13) est un circuit ouvert dans lequel circule de l'air prélevé et réintroduit dans l'environnement extérieur ; lesdits éléments de génération de flux (16) étant une pluralité de ventilateurs.

4. Système (10) selon l'une quelconque des revendications précédentes, comprenant des éléments de circulation de fluide (18) actifs dans ledit premier circuit fermé (11) pour faire circuler ledit fluide de refroidissement entre la première chambre de circulation (12) et la chambre de régénération (17).

5. Système (10) selon l'une quelconque des revendications précédentes, dans lequel ledit premier circuit fermé (11) comprend une deuxième chambre de circulation de fluide (20) formée entre le dispositif d'affichage (200) et un écran de protection (21) agencé transversalement à l'extérieur du dispositif d'affichage (200) ; ladite première (12) et deuxième chambre de circulation (17) étant en communication fluidique.

6. Système (10) selon l'une quelconque des revendications précédentes, dans lequel ladite chambre de régénération de chaleur (17) comprend un conduit vertical (19) agencé transversalement à l'extérieur dudit premier dissipateur thermique (13) et axialement à l'extérieur dudit dispositif de rétroéclairage (100) ; l'écoulement de fluide de refroidissement dans ladite première chambre de circulation (12) ayant une direction verticale et étant à contre-courant par rapport à l'écoulement de fluide de refroidissement dans ledit conduit vertical (19).

7. Système (10) selon l'une quelconque des revendications 1 à 4, comprenant un deuxième circuit fermé (23) dans lequel circule un autre fluide de refroidissement, ledit deuxième circuit fermé (23) comprenant une chambre de circulation de fluide (24) agencée entre le dispositif d'affichage (200) et un écran de protection (21) transversalement à l'extérieur du dispositif d'affichage (200) et une chambre de régénération de chaleur (25) agencée en communication fluidique avec ladite chambre de circulation (24) et associée thermiquement au deuxième dissipateur thermique (29).

8. Système (10) selon la revendication 7, dans lequel ladite chambre de régénération de chaleur (25) du deuxième circuit fermé (23) est agencée axialement entre la chambre de circulation (24) du deuxième circuit fermé (23) et dudit deuxième dissipateur thermique (29).

9. Système (10) selon la revendication 8, dans lequel ladite chambre de régénération de chaleur (25) du second circuit fermé (23) comprend un conduit vertical (27) ; l'écoulement de fluide de refroidissement dans ladite chambre de circulation (24) du deuxième circuit fermé (23) ayant une direction verticale et étant à contre-courant par rapport à l'écoulement de fluide de refroidissement dans ledit conduit vertical (27).

10. Système (10) selon l'une quelconque des revendications 7 à 9, comprenant un écran opaque (26) agencé transversalement à l'intérieur et en contact avec ledit dispositif d'affichage (200) ; ledit écran opaque (26) séparant physiquement ledit premier (11) dudit deuxième circuit fermé (23).

11. Système (10) selon l'une quelconque des revendications 7 à 10, dans lequel ladite chambre de régénération (17) du premier circuit fermé (11) est agencée transversalement à l'extérieur dudit premier dissipateur thermique (13) sur le côté opposé par rapport à la première chambre de circulation (12) ; ledit premier circuit fermé (11) entourant et reliant un ensemble composé dudit dispositif de rétroéclairage (100) et dudit premier dissipateur thermique (13).

12. Système (10) selon la revendication 11, dans lequel l'écoulement de fluide de refroidissement dans ladite première chambre de circulation (12) du premier circuit fermé (11) a une direction axiale et est à contre-courant par rapport à l'écoulement de fluide de refroidissement dans ladite chambre de régénération (17).

13. Système (10) selon l'une quelconque des revendications 7 à 12, équipé d'un autre dispositif de rétroéclairage (150) transversalement à l'extérieur et faisant face au dispositif de rétroéclairage (100) et un autre dispositif d'affichage (300) transversalement à l'extérieur de l'autre dispositif de rétroéclairage (150), sur le côté opposé par rapport à la première chambre de circulation (12), et faisant face à l'autre dispositif de rétroéclairage (150), ledit premier circuit fermé (11) s'étendant également entre l'autre dispositif de rétroéclairage (150) et l'autre dispositif d'affichage (300), dans lequel ledit fluide de refroidissement s'écoule sur ledit autre dispositif de rétroéclairage (150).

14. Système (10) selon la revendication 13, dans lequel ladite chambre de régénération de chaleur (17) du premier circuit fermé (11) est formée entre le dispositif de rétroéclairage (100) et l'autre dispositif de rétroéclairage (150) et est en communication fluidique avec la première chambre de circulation (12).

15. Système (10) selon la revendication 13 ou 14, comprenant un troisième circuit fermé (31) dans lequel circule un autre fluide de refroidissement, ledit troisième circuit fermé (31) comprenant une chambre de circulation de fluide (32) agencée entre l'autre dispositif d'affichage (300) et un autre écran de protection (34) transversalement à l'extérieur de l'autre dispositif d'affichage (300) et une chambre de régénération de chaleur (33) agencée en communication fluidique avec ladite chambre de circulation (32) et associée thermiquement à un troisième dissipateur thermique (38).

16. Système (10) selon l'une quelconque des revendications 13 à 15, comprenant un autre écran opaque (35) agencé transversalement à l'intérieur et en contact avec ledit autre dispositif d'affichage (300) ; ledit autre écran opaque (35) séparant physiquement ledit premier (11) dudit troisième circuit fermé (31).
